# EUROPÄISCHE PATENTSCHRIFT

(11) **EP 1 516 033 B1**
(45) Veröffentlichungstag und Bekanntmachung des Hinweises auf die Patenterteilung: **27.06.2007**
(21) Anmeldenummer: 03737966.6
(22) Anmeldetag: 20.05.2003
(51) Int. Cl.: C09K 11/06, C07F 15/00

(54) **VERFAHREN ZUR HERSTELLUNG VON HOCHREINEN, TRIS-ORTHO-METALLIERTEN ORGANO-IRIDIUM-VERBINDUNGEN**
METHOD FOR PRODUCING HIGHLY PURE TRIS-ORTHO METALATED ORGANOIRIDIUM COMPOUNDS
PROCEDE POUR PRODUIRE DES COMPOSES D'ORGANO-IRIDIUM TRIS-ORTHO-METALLISES TRES PURS

(30) Priorität: 25.05.2002 DE 10223337
(43) Veröffentlichungstag der Anmeldung: 23.03.2005
(73) Patentinhaber: Merck Patent GmbH, 64293 Darmstadt (DE)
(72) Erfinder: STÖSSEL, Philipp, 60487 Frankfurt/Main (DE); BACH, Ingrid, 65719 Hofheim (DE); SPREITZER, Hubert, 68519 Viernheim (DE); BECKER, Heinrich, 61479 Glashütten (DE)
(86) Internationale Anmeldenummer: PCT/EP2003/005281
(87) Internationale Veröffentlichungsnummer: WO 2003/099959

(56) Entgegenhaltungen:
- EP-A- 1 191 612
- WO-A-02/02714
- GRUSHIN V V ET AL: "New, efficient electroluminescent materials based on organometallic Ir complexes" CHEMICAL COMMUNICATIONS, ROYAL SOCIETY OF CHEMISTRY, GB, 2001, Seiten 1494-1495, XP002196401 ISSN: 1359-7345 in der Anmeldung erwähnt

## Beschreibung

Metallorganische Verbindungen - speziell Verbindungen der d⁸-Metalle - werden in naher Zukunft als Wirkkomponenten (= Funktionsmaterialien) in einer Reihe von verschiedenartigen Anwendungen, die im weitesten Sinne der Elektronikindustrie zugerechnet werden können, Einsatz als farbgebende Komponenten finden.

Bei den auf rein organischen Komponenten basierenden Organischen-Elektrolumineszenz-Vorrichtungen (allg. Beschreibung des Aufbaus siehe: US 4,539,507 und US 5,151,629) bzw. deren Einzelbauteilen, den Organischen-Lichtemittierenden-Dioden (OLEDs) ist die Markteinführung bereits erfolgt, wie die erhältlichen AutoRadios mit "Organischem Display" der Firma Pioneer belegen. Weitere derartige Produkte stehen kurz vor der Einführung. Trotzallem sind hier noch deutliche Verbesserungen nötig um diese Displays zu einer echten Konkurrenz zu den derzeit marktbeherrschenden Flüssigkristallanzeigen (LCD) zu machen bzw. diese zu überflügeln.

Eine Entwicklung hierzu, die sich in den letzten beiden Jahren abzeichnet, ist der Einsatz von metallorganischen Komplexen, die Phosphoreszenz statt Fluoreszenz zeigen [M. A. Baldo, S. Lamansky, P. E. Burrows, M. E. Thompson, S. R. Forrest, Applied Physics Letters, 1999, 75, 4-6].

Aus theoretischen Spin-statistischen Gründen ist unter Verwendung metallorganischer Verbindungen eine bis zu vierfache Energie- und Leistungseffizienz möglich. Ob sich diese neue Entwicklung durchsetzen wird, hängt zum einen stark davon ab, ob entsprechende Device-Kompositionen gefunden werden können, die diese Vorteile (Triplett-Emission = Phosphoreszenz gegenüber Singulett-Emission = Fluoreszenz) auch in den OLEDs umsetzen können. Als wesentliche Bedingungen für praktische Anwendung sind hier insbesondere eine hohe operative Lebensdauer, eine hohe Stabilität gegenüber Temperaturbelastung und eine niedrige Einsatz- und Betriebsspannung, um mobile Applikationen zu ermöglichen, zu nennen.

Zum anderen muß der effiziente chemische Zugang zu den entsprechenden, hochreinen Metallkomplexen, insbesondere zu Organo-Iridium-Verbindungen gegeben sein. Dies ist insbesondere unter Berücksichtigung des Iridiumpreises von maßgebender Bedeutung für die wirtschaftliche Nutzung der genannten Verbindungsklasse.

In EP 1191612 werden tris-ortho-metallierte Organo-Iridium-Verbindungen beschrieben, welche sich für die Verwendung in organischen Elektrolumineszenzvorrichtungen eignen und bei welchen die Summe aus Stickstoff- und Schwefelatomen im Liganden mindestens 2 beträgt. Diese Komplexe werden aus Ir(acac)₃ und dem Liganden in Ausbeuten von 11 bis 28 % erhalten.

In der Literatur sind mehrere Verfahren zur Darstellung von tris-ortho-metallierten Organo-Iridium-Verbindungen beschrieben worden. Die allgemeinen Zugangswege, die durch diese erreichten Ausbeuten und ihre Nachteile sind im folgenden kurz am Grundkörper der genannten Verbindungsklasse, dem *fac*-Tris[2-(2-pyridinyl-κN)phenyl-κC]-iridium(III), dargelegt.

Ausgehend von hydratisiertem Iridium(III)-chlorid und 2-Phenylpyridin wurde *fac-*Tris[2-(2-pyridinyl-κN)phenyl-κC]-iridium(III), nach aufwendigen chromatographischen Reinigungsverfahren, in etwa 10% iger Ausbeute erhalten [K. A. King, P. J. Spellane, R. J. Watts, J. Am. Chem. Soc., 1985, 107, 1431-1432].

K. Dedeian et al, beschreiben ein Verfahren ausgehend von Iridium(III)-acetylacetonat und 2-Phenylpyridin nach dem *fac*-Tris[2-(2-pyridinyl-κN)phenyl-κC]-iridium(III) in 45% iger Ausbeute erhalten wurde. Analog zum oben genannten Verfahren muß auch bei diesem Verfahren das Produkt durch chromatographische Verfahren von Verunreinigungen befreit werden, wobei hier - bedingt durch das Löslichkeitsverhalten - halogenierte Kohlenwasserstoffe zum Einsatz kommen [K. Dedeian, P. I. Djurovich, F. O. Garces, G. Carlson, R. J. Watts, Inorg. Chem., 1991, 30, 1685-1687].

Verschiedene substitutierte *fac-*Tris[2-(2-pyridinyl-κN)phenyl-κC]-iridium(III) Verbindungen z. B. solche mit fluorierten Liganden sind, auf diesem Weg nur in mäßigen Ausbeuten und Reinheiten z. T. auch nur in sehr geringen Ausbeuten (<20%) erhältlich.

Im nächstliegenden Stand der Technik wird Di-µ-chlorotetrakis[2-(2-pyridinyl-κN)phenyl-κC]di-iridium(III), welches zunächst in ca. 72%-iger Ausbeute aus hydratisiertem Iridium(III)-chlorid und 2-Phenylpyridin dargestellt werden muß [S. Spouse, K. A. King, P. J. Spellane , R. J. Watts J. Am. Chem. Soc., 1984, 106, 6647], als Edukt verwendet. Diese wird dann mit 2-Phenylpyridin und zweifach molaren Mengen an Silber-trifluormethansulfonat bezogen auf das Di-µ-chlorotetrakis[2-(2-pyridinyl-κN)phenyl-κC]di-iridium(III) umgesetzt. Nach chromatographischer Aufeinigung erhalten die Autoren Tris[2-(2-pyridinyl-κN)phenyl-κC]-iridium(III) in 75% iger Ausbeute [M. G. Colombo, T. C. Brunold, T. Riedener, H. U. Güdel Inorg. Chem., 1994, 33, 545-550]. Neben der chromatographischen Aufreinigung, die wiederum mit Hilfe von halogenierten Kohenwasserstoffen erfolgt, ist die Verwendung von zweifach molaren Mengen an Silber-trifluormethansulfonat bezogen auf das Di-µ-chlorotetrakis[2-(2-pyridinyl-κN)phenyl-κC]di-iridium(III) nachteilig. Verbleibende Spuren von Silberchlorid liefern kolloidales Silber, wodurch das so hergestellte Material für die Anwendung in OLED's wenig brauchbar wird.

In einem vierten literaturbekannten Verfahren wird die letztgenannte Syntheseroute direkt ausgehend von lridium(III)chlorid und den jeweiligen meist fluorierten Liganden beschritten. [S. V.V. Grushin, N. Herron, D.D. LeCloux, W. J. Marschall, V. A. Petrov, Y. Wang, J. Chem. Soc. Chem. Commun., 2001, 1494] Die erzielten Ausbeuten liegen zwischen 8 und 82% (durchschnittlich ca. 35%) abhängig von der Substitution am Phenylpyridinliganden. Auch hier werden bei der Reaktion anschließend aufwendig zu entfernende und teuere Silbersalze wie z. B. Ag(O₂CCF₃) eingesetzt.

In der nachfolgend aufgeführten Tabelle sind diese Literaturangaben zur besseren Übersicht gegenübergestellt.

**Tabelle 1 Literaturvergleich von bekannten Darstellungsverfahren.**

| | Zitat 1 | Zitat 2 | Zitat 3 | Zitat 4 |
|---|---|---|---|---|
| Edukte | IrCl₃ | Ir(acac)₃ | [Ir(ppy)₂Cl]₂ | IrCl₃ |
| | 2-Phenylpyridin | 2-Phenylpyridin | 2-Phenylpyridin | 2-Phenylpyridin |
| | | | AgO₃SCF₃ | AgO₂CCF₃ |
| Lösungsmittel | 2-Ethoxyethanol / Wasser | Ethylenglykol | keines | keines |
| Temperatur | --- | 196° - 198°C | 110°C | 170°C-195°C |
| Konzentration an Iridium-Edukt | 0.03 mol/l | 0.02 mol/l | Keine Angabe | Keine Angabe |
| Molares Verhältnis von Iridium-Edukt zu 2-Phenylpyridin | 1 : 4 | 1 : 6.3 | 1 : 15 | Keine Angabe |
| Reaktionszeit | 24 h | 10 h | 24 h | 2-9 h |
| Ausbeute | ca. 10 % | 45 % | 75 % | 8-82 % |
| | als Nebenprodukt von | | | (35%) |
| | [Ir(µ-Cl)(ppy)₂]₂ | | | |
| Reinheit nach HPLC | Keine Angabe | Keine Angabe | Keine Angabe | Keine Angabe |

| | | | | |
|---|---|---|---|---|
| Zitat 1: K. A. King, P. J. Spellane, R. J. Watts, J. Am. Chem. Soc., 1985, 107, 1431 - 1432. S. Spouse, K. A. King, P. J. Spellane, R. J. Watts, J. Am. Chem. Soc., 1984, 106, 6647 - 6653. Zitat 2: K. Dedeian, P. I. Djurovich, F. O. Garces, G. Carlson, R. J. Watts Inorg. Chem., 1991, 30, 1685-1687. Zitat 3: M. G. Colombo, T. C. Brunold, T. Riedener, H. U. Güdel Inorg. Chem., 1994, 33, 545-550. Zitat 4: V. V. Grushin, H. Herron, D.D. Lecloux, W. J., Marshall, V. A. Petrov, Y. Wang, J. Chem. Soc., Chem. Commun. 2001, 1494. | | | | |

Aufgabe dieser Erfindung war also zum einen die Bereitstellung von IridiumKomplexen mit einem einheitlichen bzw. einem gemischten Ligandensatz in hoher Reinheit. Ein weitere Aufgabe der Erfindung war es, ein Verfahren zu finden, dass ohne aufwendige Aufreinigung mittels chromatographischer Methoden auskommt.

Es wurde nun überraschend gefunden, daß Verbindungen (I) und (II) - gemäß Schema 1 - ausgehend von Iridium(III)-halogeniden, wasserfrei oder als Hydrat, oder ähnlichen Iridium(III)salzen, Iridium(III)acetonaten oder ähnlichen 1,3-Diketochelat-komplexen und Verbindungen der Formel (Ib), (IIb), in Anwesenheit von Lewis Säuren (Def. s. Jensen, Chem. Rev. 1978, 78,1) unter geeigneter Wahl der Reaktionsparameter wie Reaktionstemperatur, Konzentrationen und Reaktionszeiten, reproduzierbar in etwa 90 bis 95% iger Ausbeute, ohne die Verwendung chromatographischer Reinigungsverfahren, in Reinheiten von > 99.0% nach HPLC, erhalten werden (siehe Beispiel 2 bis 8).
Nach diesem Verfahren ergibt sich erstmals ein Zugang zu Ir-Komplexen mit gemischtem Ligandensatz wie in Verbindung (II), die Reinheiten über >99.0% aufweisen.

Gegenstand der vorliegenden Erfindung ist dem entsprechend ein Verfahren zur Herstellung von Verbindungen (I) und (II) 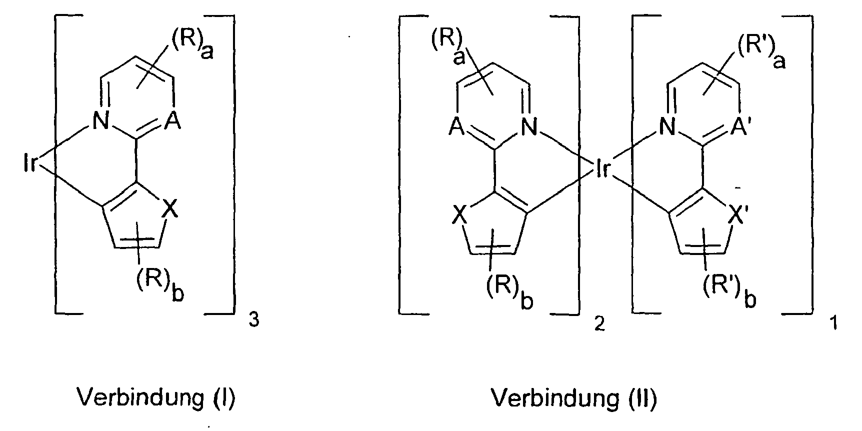 Worin
- A, A': sind gleich oder verschieden bei jedem Auftreten N oder C-H;
- X, X': sind gleich oder verschieden bei jedem Auftreten -CH=CH-, -CR=CH-,-CR=CR-, N-H, N-R¹, O, S oder Se; bevorzugt -CH=CH-, -CR=CH- oder S;
- R, R': ist gleich oder verschieden bei jedem Auftreten F, Cl, Br, NO₂, CN, eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -NR¹-, oder -CONR² - ersetzt sein können und wobei ein oder mehrere H-Atome durch F ersetzt sein können, oder eine Aryl- oder Heteroarylgruppe mit 4 bis 14 C-Atomen, die durch einen oder mehrere, nicht aromatische Reste R substituiert sein kann; wobei mehrere Substituenten R, sowohl am selben Ring als auch an den beiden unterschiedlichen Ringen zusammen wiederum ein weiteres mono- oder polycyclisches Ringsystem aufspannen können;
- R¹ und R²: sind gleich oder verschieden, H oder ein aliphatischer oder aromatischer Kohlenwasserstoffrest mit 1 bis 20 C-Atomen;
- a: ist 0, 1, 2, 3 oder 4, bevorzugt 0 oder 1;
- b: ist 0, 1 oder 2.
durch Umsetzung einer Verbindung (Ia), (IIa) oder (IIIa)
worin 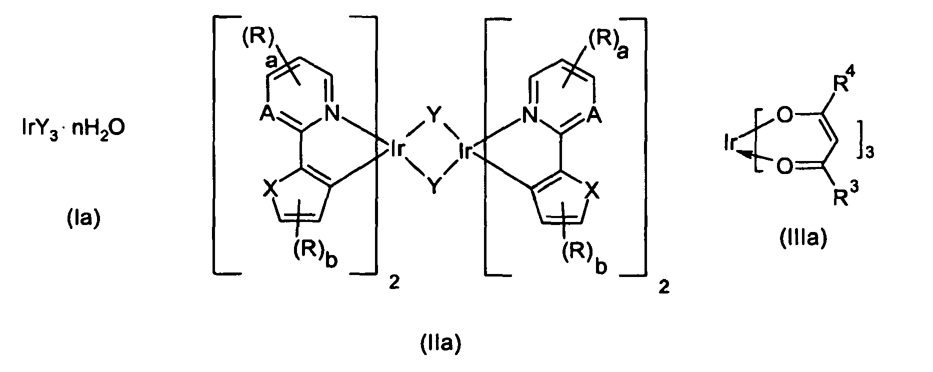
- Y: ist gleich F, Cl, Br, OH oder eine geradkettige oder verzweigte oder cyclische Alkoxygruppe mit 1 bis 8 C-Atomen oder eine Phenoxygruppe,
- R³, R⁴: sind gleich oder verschieden bei jedem Auftreten und haben die Bedeutung von R¹ und R² oder CF₃.
mit einer Verbindungen (Ib)/ (IIb) 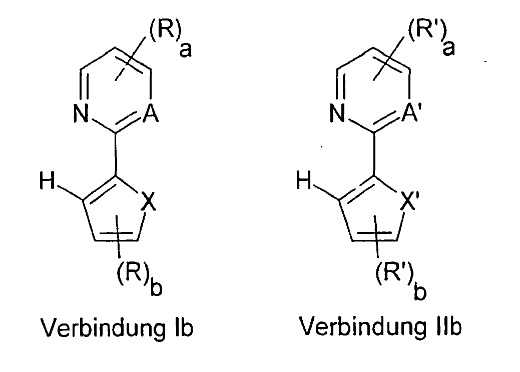 worin die Reste A, A', X, X', R, R', a und b die oben genannten Bedeutungen haben, unter Zusatz einer Lewissäure.

Das erfindungsgemäße Verfahren wird durch das Schema 1 erläutert.

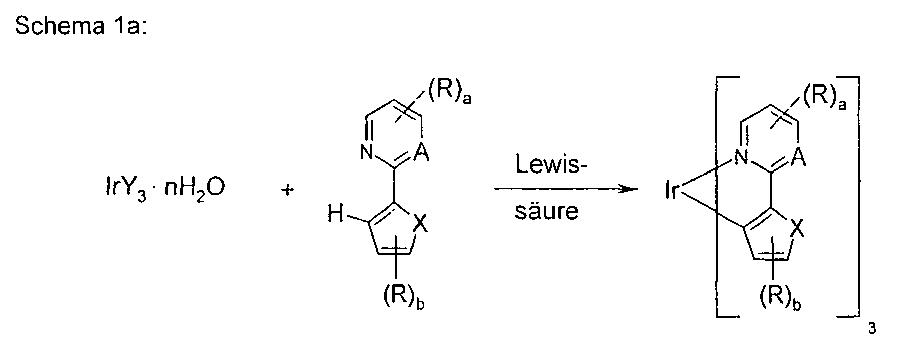

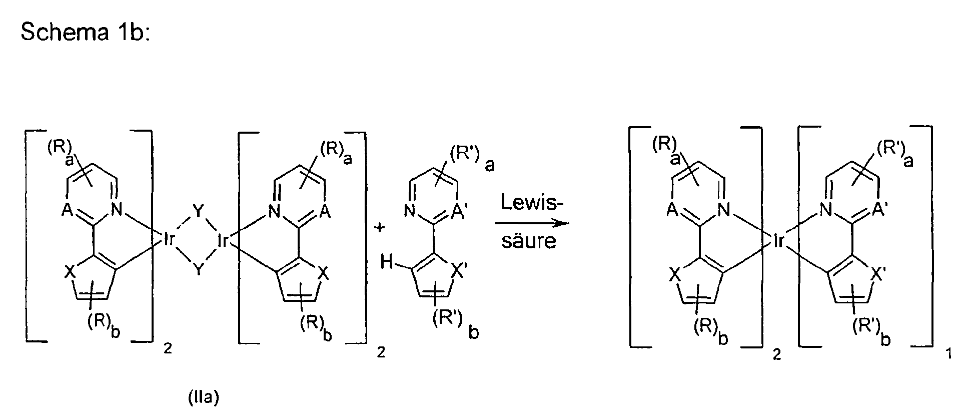

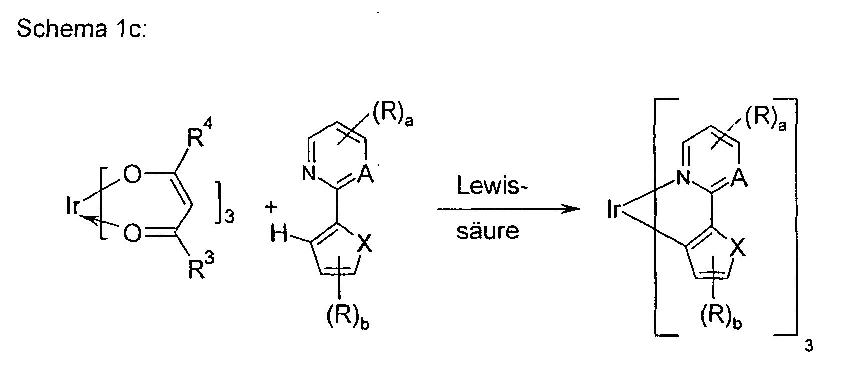

Erfindungsgemäße Iridiumhaltige Edukte sind Iridiumhalogenide, wasserfrei oder als Hydrat, wie z. B. IrCl₃, IrCl₃ n H₂O, IrBr₃, IrBr₃ n H₂O besonders bevorzugt IrCl₃ n H₂O, oder zweikernige Iridiumkomplexe der Formel (IIa) wie z. B. Di-µ-chloro-tetrakis[(2-pyridinyl-κN)(phenyl)-κC]-di-iridium(III), Di-µ-chloro-tetrakis[(2-pyridinyl-κN)(4',6'-difluorphenyl)-κC]-di-iridium(III), Di-µ-chloro-tetrakis[(2-(3-methyl)pyridinyl-κN)(6'-methylphenyl)-κC]-di-iridium(III), Di-µ-chloro-tetrakis[(2-(3-trifluormethyl)pyridinyl-κN)(6'-fluorphenyl)-κC]-di-iridium(III), Di-µ-chloro-tetrakis[(2-pyridinyl-κN)(4'-fluorphenyl)-κC]-di-iridium(III), Di-µ-chloro-tetrakis[(2-pyridinyl-κN)(4'fluorphenyl)-κC]-di-iridium(III), Di-µ-chloro-tetrakis[(2-(3-trifluormethyl)pyridinyl-κN)(phenyl)-κC]-di-iridium(III), Di-µ-chloro-tetrakis[(2-bis(3,5-trifluormethyl)pyridinyl-κN)(phenyl)-κC]-di-iridium(III) oder Ir(III)acetylacetonat.

Bevorzugte Lewis-Säuren sind solche, die als Lewis-saures Zentrum ein Element der 3. und/oder 4. Hauptgruppe und /oder der 2. bis 10. Nebengruppe enthalten.

Besonders bevorzugte Lewis-Säuren enthalten als ein Element der 3. und/oder 4. Hauptgruppe B, Al oder Sn, wie z.B. Trimethylborat, Triethylborat , Triisopropylborat, Bortrifluorid Etherkomplex, Aluminium(III)fluorid, -(III)chlorid, -(III)bromid, -(III)iodid, -(III)butanolat, -(III)ethanolat, -(III)isopropanolat, -(III)phenolat, Zinn(II)chlorid, -(II)bromid, -(II)fluorid, -(II)iodid, -(IV)chlorid, -(IV)bromid, -(IV)fluorid, oder -(IV)iodid.

Besonders bevorzugte Lewis-Säuren enthalten als ein Element der 2. bis 10. Nebengruppe Fe, Zn, Ti, oder Zr, wie z.B. Eisen(III)chlorid, -(III)bromid, -(III)iodid, Eisen(II)chlorid, -(II)bromid, -(II)iodid, Zink(II)chlorid, -(II)bromid, -(II)iodid, Titan- oder Zirkon(IV)chlorid, -(IV)bromid, -(IV)fluorid, -(IV)iodid, , -(IV)ethanolat, -(IV)butanolat, -(IV)methanolat, -(IV)chloridtriethanolat, -(IV)chloridtrüsopropanolat, -(IV)(2-ethylhexylat), -(IV)fluorid.

Ausdrücklich ausgenommen sind Silbersalze, da die damit hergestellten IridiumKomplexe auch nach aufwendiger Reinigung Spuren von Silbersalzen oder von kolloidalem Silber enthalten, wodurch die so hergestellten Materialien für die Anwendung in OLED's wenig brauchbar sind.

Das erfindungsgemäße molare Verhältnis der Lewissäure zum Iridium-haltigen Edukt, beträgt 0,01:1 bis 10:1, bevorzugt ist ein Verhältnis von 1:1 bis 5:1, besonders bevorzugt ist ein Verhältnis von 2:1 bis 4:1.

Erfindungsgemäße Reaktionsmedien sind die Verbindungen der Formel (Ib), (IIb) selbst, vorausgesetzt diese sind unter den Reaktionsbedingungen flüssig, sowie hochsiedende aprotische oder protische Lösungsmittel wie z. B. Dekalin, Naphthalin, Dimethylsulfoxid, Xylol, Anisol, Ethylenglykol, Propylenglykol, Triethylenglykoldimethylether, Poly-(ethylenglykol)-dimethylether oder N-Methyl-pyrrolidinon (NMP), Fluorwasserstoff oder überkritisches Kohlendioxid, besonders bevorzugt Dekalin und Verbindungen der Formel (Ib) und /oder (IIb).

Erfindungsgemäß wird die Umsetzung in einem Temperaturbereich von 110°C bis 220°C, bevorzugt im Bereich von 130°C bis 200°C durchgeführt.

Das erfindungsgemäße molare Verhältnis des Iridium-haltigen Edukts der Formel (la oder IIIa) zum Aryl-pyridin-Derivat bzw. Aryl-pyrimidin-Derivat (Verbindungen der Formel (Ib) beträgt 1:3 bis 1:100, bevorzugt ist ein Verhältnis von 1:5 bis 1:50, besonders bevorzugt ist ein Verhältnis von 1:10 bis 1:20.
Im Falle der Synthese der Verbindung (II) ausgehend von den zweikernigen Iridiumkomplexen der Formel (IIa) beträgt das Verhältnis des Iridium-haltigen Edukts zum Arylpyridin-Derivat bzw. Aryl-pyrimidin-Derivat der Formel (Ib) oder (IIb) 1:1 bis 1:100, bevorzugt ist ein Verhältnis von 1:3 bis 1:60, besonderes bevorzugt ist ein Verhältnis von 1:4 bis 1:20.
Eine Unterschreitung der oben genannten Konzentrationen führt neben geringerem Umsatz zur Bildung von Nebenprodukten, und damit zur Verunreinigung des Produkts.

Erfindungsgemäß wird die Reaktion innerhalb von 2 bis 120 h durchgeführt, bevorzugt im Bereich von 5 bis 80 h. Eine Unterschreitung der genannten Reaktionszeit hat einen unvollständigen Umsatz des eingesetzten Iridium-haltigen Edukts was zu Ausbeuteverlusten und zur Verunreinigung des Produkts führt.

Die im Stand der Technik beschriebenen Verbindungen der Formel (I) und (II) sind bislang maximal in Reinheiten von bis zu 96% zugänglich gewesen oder waren mittels aufwendiger chromatographischer Methoden aufzureinigen. Durch die erfindungsgemäße Herstellung können jedoch Verbindungen der Formel (I) und (II) in Reinheiten von mehr als 99%, bevorzugt von mehr als 99.9% erhalten werden. Derart reine Verbindungen - dies gilt inbesondere für Verbindungen (II) mit einem gemischten Ligandensatz - waren bislang nicht bekannt. Die vorliegende Erfindung wird durch die nachfolgenden Beispiele näher erläutert, ohne jedoch diese auf die Beispiele einschränken zu wollen. Dem Fachmann auf dem Gebiet der organischen Synthese sollte es hiermit ohne weitere erfinderische Tätigkeit möglich sein, an weiteren Systemen - wie oben beschrieben - die erfindungsgemäßen Umsetzungen durchzuführen.

### Beispiel 1: Synthese von tris-ortho-metallierten Organo-lridium-Verbindungen:

Die nachfolgenden Synthesen wurden bis zur Aufarbeitung unter einer trockenen Rein-Stickstoffatmosphäre oder -Argonatmosphäre unter Verwendung sorgfältig getrockneter Lösungsmittel durchgeführt. Die verwendeten Edukte wurden bei ALDRICH [Dekalin, Iridium(III)-chlorid n H₂O, 2-Phenylpyridin] bezogen und ohne weitere Reinigung verwendet. bzw. nach literaturbekannten Verfahren [Di-µ-chloro-tetrakis[(2-pyridinyl-κN)(Phenyl)-κC]-di-iridium(III) und Derivate : J. Sprouse, K.A. King, P. J. Spellane J. Am. Chem. Soc. 1984, 106, 6647.] hergestellt.

Schema 2: Die Position der Substituenten wurden wie folgt, beziffert.

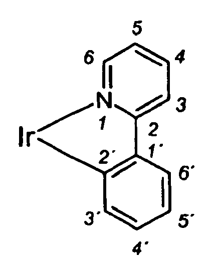

### Vergleichsbeispiel 1 (analog zu Zitat 4, V. V. Grushin, H. Herron, D.D. Lecloux, W. J., Marshall, V. A. Petrov, Y. Wang, J. Chem. Soc., Chem. Commun. 2001, 1494) : fac-Tris[2'-(2-pyridinyl-κN)-4',6'-difluorphenyl-κC]-indium(III)

Zu 6.07 g (5.0 mmol) Di-µ-chloro-tetrakis[(2-pyridinyl-κN)(4',6'-difluorphenyl)-κC]-di-iridium(III) und 2.42 g (10.8 mmol) Silbertrifluoracetat wurden 23.72 g (123.8 mmol) 2-(2,4-Difluorphenyl)pyridin zugefügt. Die Reaktionsmischung wurde für 20 h bei 190°C gerührt. Anschließend wurde die Reaktionsmischung auf eine Mischung aus 600 ml Ethanol und 600 ml 1 N Salzsäure gegossen. Nach 5 minütigen Rühren wurde über eine Glasfilternutsche (P4) abgesaugt, der gelbe, feinkristalline Niederschlag wurde drei Mal mit 50 ml einer Mischung aus Ethanol und Wasser (1:1) und dreimal mit 30 ml Ethanol gewaschen. Schließlich wurde der Feststoff 20h bei 30°C im Ölpumpenvakuum getrocknet. Die Ausbeute bei einer Reinheit von 90.0-93.4% nach NMR- betrug 5.42-5.75 g entsprechend 71.2- 75.4%
¹H NMR (d²Tetrachlorethan, genannt im folgenden TCE): [ppm] = 8.47(d, ³*J*_{H} = 8.7 Hz, 3H), 7.89 (dd, 3H), 7.65 (dd,3H), 7.15 (dd, 3H), 6.60(m, 3H), 6.41(dd, 3H).

### Beispiel 2: fac-Tris[2-(2-pyridinyl-κN) 4',6'-difluorphenyl-κC]-iridium(III)

Zu 6.07 g (5.0 mmol) Di-µ-chloro-tetrakis[(2-pyridinyl-κN)(4',6'-difluorphenyl)-κC]-di-iridium(III) und 1.55 g (10.8 mmol) Aluminium(III)chlorid wurden 23.72 g (123.8 mmol) 2-(2,4-Difluorphenyl)pyridin zugefügt. Die Reaktionsmischung wurde für 5 h bei 190°C gerührt. Anschließend wurde die Reaktionsmischung auf eine Mischung aus 600 ml Ethanol und 600 ml 1 N Salzsäure gegossen. Nach 5 minütigen Rühren wurde über eine Glasfilternutsche (P4) abgesaugt, der gelbe, feinkristalline Niederschlag wurde drei mal mit 50 ml einer Mischung aus Ethanol und Wasser (1:1) und dreimal mit 30 ml Ethanol gewaschen. Schließlich wurde der Feststoff 5h bei 30°C im Ölpumpenvakuum getrocknet. Die Ausbeute bei einer Reinheit von > 99.0% nach NMR- betrug 7.01-7.32 g entsprechend 91.9-95.9%.
¹H NMR (TCE): [ppm] s. Beispiel 1.

### Beispiel 3: fac-Tris[2-(2-pyridinyl-κN) 4',6'-difluorphenyl-κG]-iridium(III)

Zu 6.07 g (5.0 mmol) Di-µ-chloro-tetrakis[(2-pyridinyl-κN)(4',6'-difluorphenyl)-κC]-di-iridium(III) und 1.62 g (11.8 mmol) Zink(II)chlorid wurden 23.73 g (123.8 mmol) 2-(2,4-Difluorphenyl)pyridin zugefügt. Die Reaktionsmischung wurde für 24 h bei 140°C gerührt. Aufarbeitung siehe Beispiel 2. Die Ausbeute bei einer Reinheit von >99.0% nach NMR- betrug 6.98-7.30 g entsprechend 91.5-95.7%.
¹H NMR (TCE): [ppm] s. Beispiel 1.

### Beispiel 4: Bis [(2-pyridinyl-κN)phenyl)-κC]mono[2-(2-pyridinyl-κN)(4',6'-difluorphenyl-κC]-iridium(III)

Zu 5.36 g (5.0 mmol) Di-µ-chloro-tetrakis[(2-pyridinyl-κN)phenyl-κC]-di-iridium(III) und 1.55 g (10.8 mmol) Aluminium(III)chlorid wurden 23.73 g (123.8 mmol) 2-(2,4-Difluorphenyl)pyridin. Die Reaktionsmischung wurde für 20 h bei 140°C gerührt. Aufarbeitung siehe Beispiel 2. Die Ausbeute bei einer Reinheit von >99.0% nach NMR- betrug 6.46-6.57 g entsprechend 93.5-95.3%.

### Beispiel 5: fac-Tris[2-(2-pyridinyl-κN)4',6'-difluorphenyl-κC]-iridium(III)

Zu 1.52 g (5.0 mmol) Iridium(III)chlorid hydrat und 2.66 g (20 mmol) Aluminium(III)chlorid wasserfrei wurden 19.37 g (100 mmol) 2,4-Difluorphenylpyridin zugesetzt und für 70 h bei 180°C gerührt. Aufarbeitung siehe Beispiel 2. Die Ausbeute bei einer Reinheit von >99.0% betrug 3.59-3.67g entsprechend 94.3-96.4%.
¹H NMR (TCE): [ppm] s. Beispiel 1.

### Beispiel 6: fac-Tris[2-(2-pyridinyl-κN)phenyl-κC]-iridium(III)

Zu 1.52 g (5.0 mmol) Iridium(III)chlorid hydrat und 2.72 g (20 mmol) Zink(II)chlorid wasserfrei wurden 15.52 g (100 mmol) Phenylpyridin zugesetzt und für 70 h bei 150°C gerührt. Aufarbeitung siehe Beispiel 2. Die Ausbeute bei einer Reinheit von 99.0-99.5% betrug 2.96-3.13 g entsprechend 90.4-95.8 %.
¹H NMR (CDCl₃): [ppm] = 7.84 (m, 3 H), 7.58 (m, 6 H), 7.48 (m, 3 H), 6.82 (m, 6 H), 6.69 (m, 6 H).

### Beispiel 7: fac-Tris[2-(2-pyridinyl-κN) 4',6'-difluorphenyl-κC]-iridium(III)

Zu 6.07 g (5.0 mmol) Di-µ-chloro-tetrakis[(2-pyridinyl-κN)(4',6'-difluorphenyl)-κC]-di-iridium(III) und 1.55 g (10.8 mmol) Aluminium(III)chlorid wurden 3.00 g (15.7 mmol) 2-(2,4-Difluorphenyl)pyridin und 150 ml Dekalin zugefügt. Die Reaktionsmischung wurde für 48 h bei 180°C gerührt. Aufarbeitung siehe Beispiel 2. Die Ausbeute bei einer Reinheit von > 99.0% 7.29-7.38 g entsprechend 95.5-96.8%
¹H NMR (TCE): [ppm] s. Beispiel 1.

### Beispiel 8: fac-Tris[2-(2-pyridinyl-κN) 4',6'-difluorphenyl-κC]-iridium(III)

Zu 6.07 g (5.0 mmol) Di-µ-chloro-tetrakis[(2-pyridinyl-κN)(4',6'-difluorphenyl)-κC]-di-iridium(III) und 0.15 g (1.1 mmol) Aluminium(III)chlorid wurden 3.00 g (15.7 mmol) 2-(2,4-Difluorphenyl)pyridin und 150 ml Dekalin zugefügt. Die Reaktionsmischung wurde für 80 h bei 180°C gerührt. Aufarbeitung siehe Beispiel 2. Die Ausbeute bei einer Reinheit von > 99.0% 7.25-7.41 g entsprechend 95.1-97.2%
¹H NMR (TCE): [ppm] s. Beispiel 1.

## Patentansprüche

1. Verfahren zur Herstellung von Verbindungen (I) und (II) 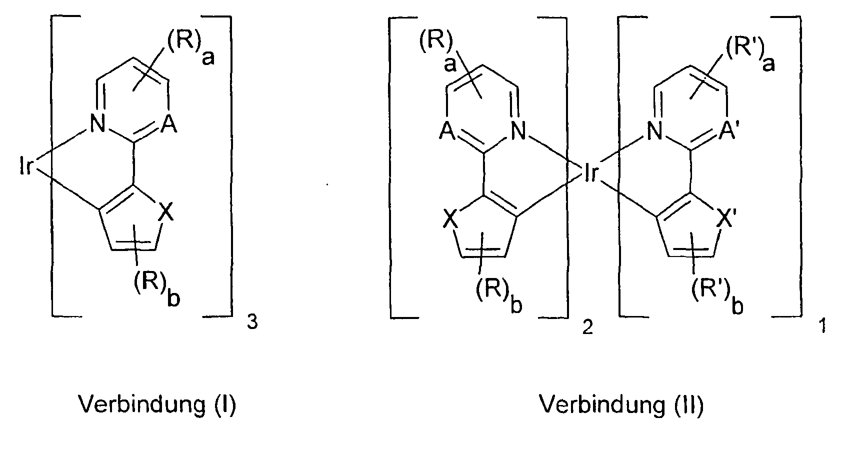 worin
A, A' sind gleich oder verschieden bei jedem Auftreten N oder C-H;
X, X' sind gleich oder verschieden bei jedem Auftreten -CH=CH-, -CR=CH-,-CR=CR-, N-H, N-R¹, O, S oder Se; bevorzugt -CH=CH-, -CR=CH- oder S;
R, R' ist gleich oder verschieden bei jedem Auftreten F, Cl, Br, NO₂, CN, eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -NR¹-, oder -CONR²- ersetzt sein können und wobei ein oder mehrere H-Atome durch F ersetzt sein können, oder eine Aryl- oder Heteroarylgruppe mit 4 bis 14 C-Atomen, die durch einen oder mehrere, nicht aromatische Reste R substituiert sein kann; wobei mehrere Substituenten R, sowohl am selben Ring als auch an den beiden unterschiedlichen Ringen zusammen wiederum ein weiteres mono- oder polycyclisches Ringsystem aufspannen können;
R¹ und R² sind gleich oder verschieden, H oder ein aliphatischer oder aromatischer Kohlenwasserstoffrest mit 1 bis 20 C-Atomen,
a ist 0, 1, 2, 3 oder 4;
b ist 0, 1 oder 2;
durch Umsetzung einer Verbindung (la), (IIa), (IIIa) 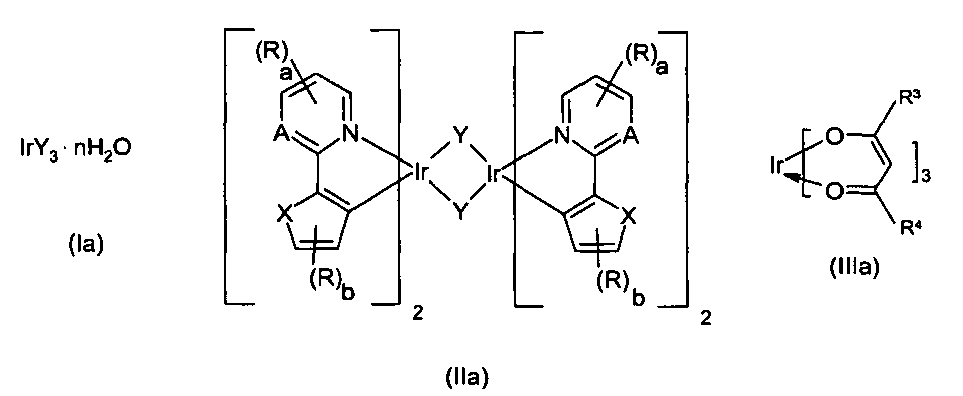 worin
Y ist gleich F, Cl, Br, OH oder eine geradkettige oder verzweigte oder cyclische Alkoxygruppe mit 1 bis 8 C-Atomen oder eine Phenoxygruppe,
R³, R⁴ sind gleich oder verschieden bei jedem Auftreten und haben die Bedeutung von R¹ und R² oder CF₃;
mit einer Verbindung (Ib), (IIb) 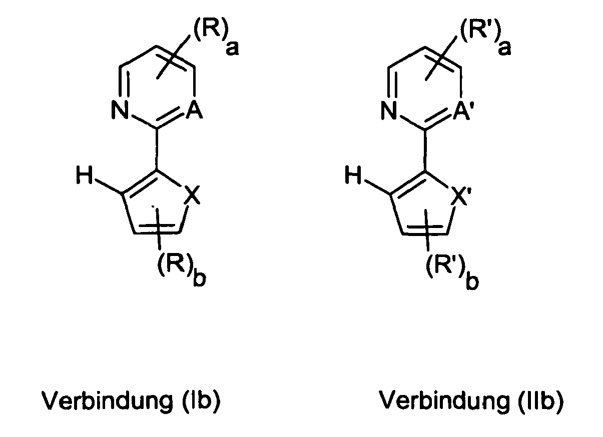 worin die Reste A, A', X, X', R, R', a und b die oben genannten Bedeutungen haben, unter Zusatz einer Lewis-Säure.

2. Verfahren gemäß Anspruch 1, **dadurch gekennzeichnet, dass** als Iridium haltiges Edukt IrCl₃, IrCl₃ n H₂O, IrBr₃, IrBr₃ n H₂O, Di-µ-chloro-tetrakis[(2-pyridinyl-κN)(phenyl)-κC]-di-iridium(III), Di-µ-chloro-tetrakis[(2-pyridinyl-κN)(4',6'-difluorphenyl)-κC]-di-iridium(III), Di-µ-chloro-tetrakis[(2-(3-methyl)pyridinyl-κN)(6'-methy(phenyl)-κC]-di-iridium(III), Di-µ-chloro-tetrakis[(2-(3-trifluormethyl)pyridinyl-κN)(6'-fluorphenyl)-κC]-di-iridiurn(III), Di-µ-chloro-tetrakis[(2-pyridinyl-κN)(4'-fluorphenyl)-κC]-di-iridium(III), Di-µ-chloro-tetrakis[(2-pyridinyl-κN)(4'fluorphenyl)-κC]-di-iridium(III), Di-µ-chloro-tetrakis[(2-(3-trifluormethyl)pyridinyl-κN)(phenyl)-κC]-di-iridium(III), Di-µ-chloro-tetrakis[(2-bis(3,5-trifluormethyl)pyridinyl-κN)(phenyl)-κC]-di-iridium(III), oder Ir(III)acetylacetonat eingesetzt wird.

3. Verfahren gemäß den Ansprüchen 1 und/oder 2, **dadurch gekennzeichnet, dass** die Lewis-Säure als Lewis-saures Zentrum ein Element der 3. und/oder 4. Hauptgruppe und /oder der 2. bis 10. Nebengruppe enthält.

4. Verfahren gemäß einem oder mehreren der Ansprüche 1 bis 3, **dadurch gekennzeichnet, dass** die Lewis-Säure als Lewis-saures Zentrum ein Element der 3. und/oder 4. Hauptgruppe enthält, bevorzugt B, Al oder Sn.

5. Verfahren gemäß einem oder mehreren der Ansprüche 1 bis 4, **dadurch gekennzeichnet, dass** als Lewis-Säure Trimethylborat, Triethylborat , Triisopropylborat, Bortrifluorid Etherkomplex, Aluminium(III)fluorid, -(III)chlorid, -(III)bromid, -(III)iodid, -(III)butanolat, -(III)ethanolat, -(III)isopropanolat, -(III)phenolat, Zinn(II)chlorid, -(II)bromid, -(II)fluorid, -(II)iodid, -(IV)chlorid, -(IV)bromid, -(IV)fluorid, oder -(IV)iodid verwendet wird.

6. Verfahren gemäß einem oder mehreren der Ansprüche 1 bis 3, **dadurch gekennzeichnet, dass** die Lewis-Säure als Lewis-saures Zentrum ein Element der 2. bis 10. Nebengruppe enthält, bevorzugt Fe, Zn, Ti, oder Zr.

7. Verfahren gemäß einem oder mehreren der Ansprüche 1 bis 3 und 6, **dadurch gekennzeichnet, dass** als Lewissäure Eisen(III)chlorid, -(III)bromid, -(III)iodid, Eisen(II)chlorid, -(II)bromid, -(II)iodid, Zink(II)chlorid, -(II)bromid, -(II)iodid, Titan- oder Zirkon(IV)chlorid, -(IV)bromid, -(IV)fluorid, -(IV)iodid, -(IV)ethanolat, -(IV)butanolat, -(IV)methanolat, -(IV)chloridtriethanolat, -(IV)chloridtriisopropanotat, -(IV)(2-ethylhexylat), -(IV)fluorid, eingesetzt wird.

8. Verfahren gemäß einem oder mehreren der Ansprüche 1 bis 7, **dadurch gekennzeichnet, dass** gegebenenfalls Mischungen von Lewis-Säuren verwendet werden.

9. Verfahren gemäß einem oder mehreren der Ansprüche 1 bis 8, **dadurch gekennzeichnet, dass** die Lewis-Säure im Verhältnis zum Iridiumhaltigen Edukt von 0,01:1 bis 10:1 1 eingesetzt wird.

10. Verfahren gemäß einem oder mehreren der Ansprüche 1 bis 9, **dadurch gekennzeichnet, dass** das Verhältnis von Iridiumhaltigen Edukt, Verbindungen der Formel (Ia,IIa, IIIa) und Ligand der Formel (Ib, IIb) 1:1 bis 1:100 beträgt.

11. Verfahren gemäß einem oder mehreren der Ansprüche 1 bis 10, **dadurch gekennzeichnet, daß** als Lösemittel Dekalin, Naphthalin, Dimethylsulfoxid, Xylol, Anisol, Ethylenglykol, Propylenglykol, Triethylenglykoldimethylether, Poly-(ethylenglykol)-dimethylether oder N-Methyl-pyrrolidinon (NMP), Fluorwasserstoff oder überkritisches Kohlendioxid verwendet wird.

12. Verfahren gemäß einem oder mehreren der Ansprüche 1 bis 11, **dadurch gekennzeichnet, daß** die Umsetzung in einem Temperaturbereich von 110°C bis 220°C, bevorzugt 130 bis 200°C durchgeführt wird.

13. Verfahren gemäß einem oder mehreren der Ansprüche 1 bis 12, **dadurch gekennzeichnet, daß** die Reaktion innerhalb von 5 bis 80h durchgeführt wird.

## Claims

1. Process for the preparation of compounds (I) and (II) 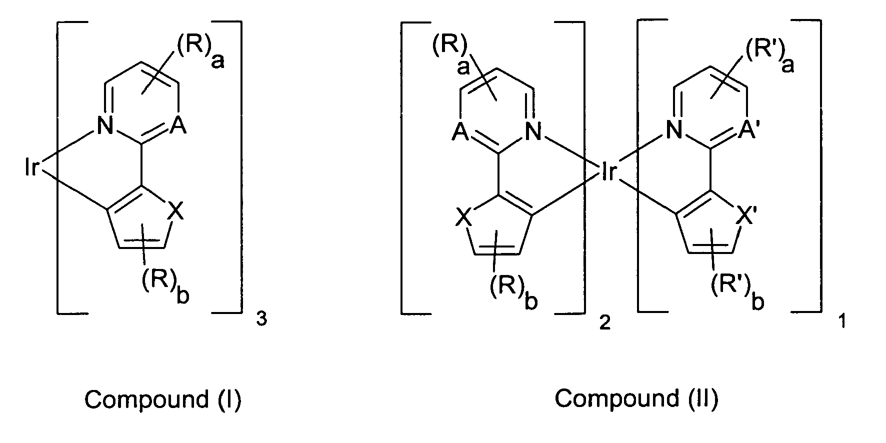 in which
A, A' are, identically or differently on each occurrence, N or C-H;
X, X' are, identically or differently on each occurrence, -CH=CH-, -CR=CH-, -CR=CR-, N-H, N-R¹, O, S or Se; preferably -CH=CH-, -CR=CH- or S;
R, R' are, identically or differently on each occurrence, F, Cl, Br, NO₂, CN, a straight-chain or branched or cyclic alkyl or alkoxy group having 1 to 20 C atoms, in which one or more non-adjacent CH₂ groups may be replaced by -O-, -S-, -NR¹- or -CONR²- and in which one or more H atoms may be replaced by F, or an aryl or heteroaryl group having 4 to 14 C atoms, which may be substituted by one or more non-aromatic radicals R; where a plurality of substituents R, both on the same ring and also on the two different rings, may together in turn form a further mono- or polycyclic ring system;
R¹ and R² are, identically or differently, H or an aliphatic or aromatic hydrocarbon radical having 1 to 20 C atoms;
a is 0, 1, 2, 3 or 4;
b is 0, 1 or 2;
by reaction of a compound (Ia), (IIa), (IIIa) 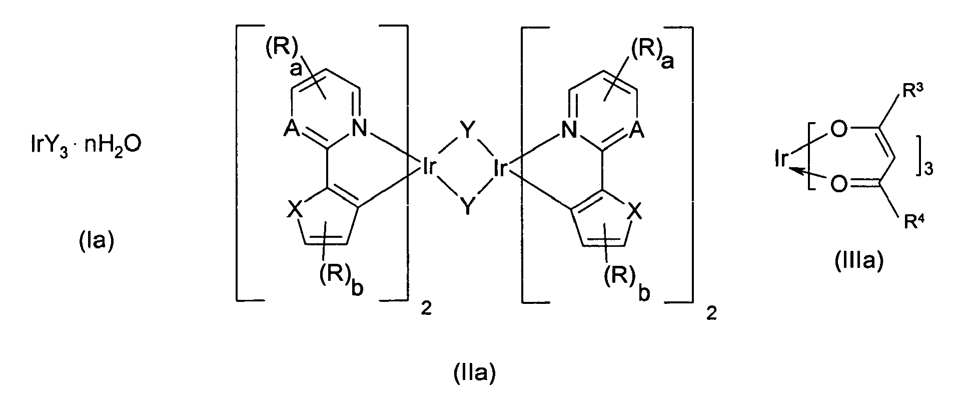 in which
Y is identically F, Cl, Br, OH or a straight-chain or branched or cyclic alkoxy group having 1 to 8 C atoms or a phenoxy group,
R³, R⁴ are identical or different on each occurrence and have the meaning of R¹ and R² or CF₃;
with a compound (Ib), (IIb) 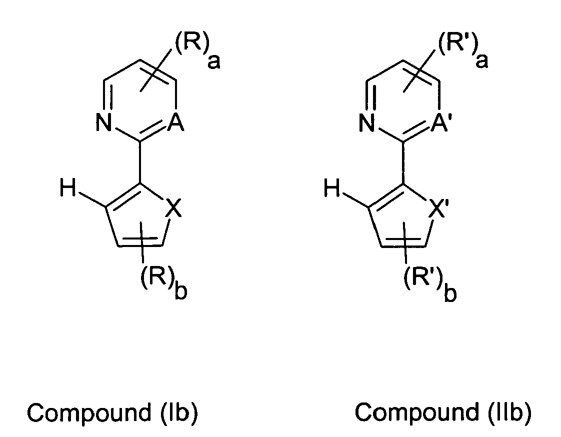 in which the radicals A, A', X, X', R, R', a and b have the meanings mentioned above, with addition of a Lewis acid.

2. Process according to Claim 1, **characterised in that** the iridium-containing starting material employed is IrCl₃, IrCl₃ n H₂O, IrBr₃, IrBr₃ n H₂O, di-µ-chlorotetrakis[(2-pyridinyl-κN)(phenyl)-κC]diiridium(III), di-µ-chlorotetrakis[(2-pyridinyl-κN)(4',6'-difluorophenyl)-κC]diiridium(III), di-µ-chlorotetrakis[(2-(3-methyl)pyridinyl-κN)(6'-methylphenyl)-κC]diiridium(III), di-µ-chlorotetrakis[(2-(3-trifluoromethyl)pyridinyl-κN)-(6'-fluorophenyl)-κC]diiridium(III), di-µ-chlorotetrakis[(2-pyridinyl-κN)(4'-fluorophenyl)-κC]diiridium(III), di-µ-chlorotetrakis[(2-pyridinyl-κN)(4'-fluorophenyl)-κC]diiridium(III), di-µ-chlorotetrakis[(2-(3-trifluoromethyl)pyridinyl-κN)(phenyl)-κC]diiridium(III), di-µ-chlorotetrakis[(2-bis(3,5-trifluoromethyl)pyridinyl-κN)(phenyl)-κC]diiridium(III) or Ir(III) acetylacetonate.

3. Process according to Claims 1 and/or 2, **characterised in that** the Lewis acid contains, as Lewis-acidic centre, an element from main group 3 and/or 4 and/or sub-group 2 to 10.

4. Process according to one or more of Claims 1 to 3, **characterised in that** the Lewis acid contains, as Lewis-acidic centre, an element from main group 3 and/or 4, preferably B, Al or Sn.

5. Process according to one or more of Claims 1 to 4, **characterised in that** the Lewis acid used is trimethyl borate, triethyl borate, triisopropyl borate, boron trifluoride/ether complex, aluminium(III) fluoride, aluminium(III) chloride, aluminium(III) bromide, aluminium(III) iodide, aluminium(III) butoxide, aluminium(III) ethoxide, aluminium(III) isopropoxide, aluminium(III) phenoxide, tin(II) chloride, tin(II) bromide, tin(II) fluoride, tin(II) iodide, tin(IV) chloride, tin(IV) bromide, tin(IV) fluoride or tin(IV) iodide.

6. Process according to one or more of Claims 1 to 3, **characterised in that** the Lewis acid contains, as Lewis-acidic centre, an element from sub-group 2 to 10, preferably Fe, Zn, Ti or Zr.

7. Process according to one or more of Claims 1 to 3 and 6, **characterised in that** the Lewis acid employed is iron(III) chloride, iron(III) bromide, iron(III) iodide, iron(II) chloride, iron(II) bromide, iron(II) iodide, zinc(II) chloride, zinc(II) bromide, zinc(II) iodide, titanium(IV) or zirconium(IV) chloride, titanium(IV) or zirconium(IV) bromide, titanium(IV) or zirconium(IV) fluoride, titanium(IV) or zirconium(IV) iodide, titanium(IV) or zirconium(IV) ethoxide, titanium(IV) or zirconium(IV) butoxide, titanium(IV) or zirconium(IV) methoxide, titanium(IV) or zirconium(IV) chloride triethoxide, titanium(IV) or zirconium(IV) chloride triisopropoxide, titanium(IV) or zirconium(IV) (2-ethylhexoxide), titanium(IV) or zirconium(IV) fluoride.

8. Process according to one or more of Claims 1 to 7, **characterised in that** mixtures of Lewis acids are optionally used.

9. Process according to one or more of Claims 1 to 8, **characterised in that** the Lewis acid is employed in the ratio 0.01:1 to 10:1 to the iridium-containing starting material.

10. Process according to one or more of Claims 1 to 9, **characterised in that** the ratio of iridium-containing starting material, compounds of the formula (la, IIa, IIIa) and ligand of the formula (Ib, IIb) is 1:1 to 1:100.

11. Process according to one or more of Claims 1 to 10, **characterised in that** the solvent used is decalin, naphthalene, dimethyl sulfoxide, xylene, anisole, ethylene glycol, propylene glycol, triethylene glycol dimethyl ether, poly(ethylene glycol) dimethyl ether or N-methylpyrrolidinone (NMP), hydrogen fluoride or supercritical carbon dioxide.

12. Process according to one or more of Claims 1 to 11, **characterised in that** the reaction is carried out in a temperature range from 110°C to 220°C, preferably 130 to 200°C.

13. Process according to one or more of Claims 1 to 12, **characterised in that** the reaction is carried out over the course of 5 to 80 h.

## Revendications

1. Procédé pour la préparation de composés (I) et (II) 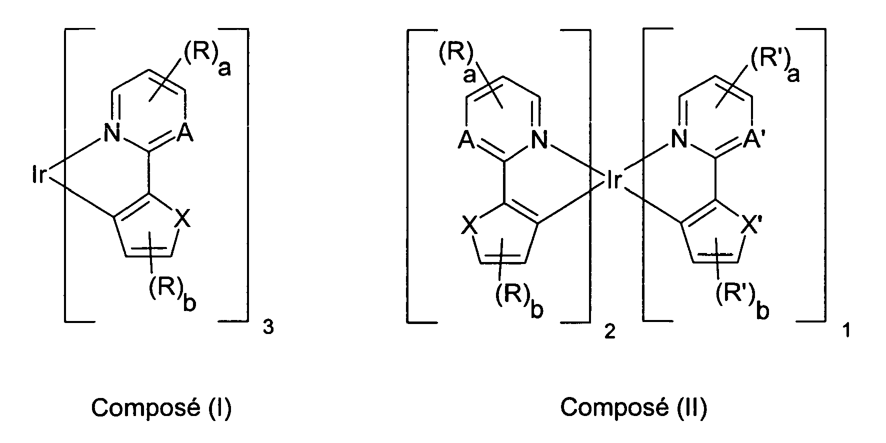 dans lesquels
A, A' sont, de manière identique ou différente lors de chaque occurrence, N ou C-H;
X, X' sont, de manière identique ou différente lors de chaque occurrence, -CH=CH-, -CR=CH-, -CR=CR-, N-H, N-R¹, O, S ou Se; de préférence -CH=CH-, -CR=CH- ou S;
R, R' sont, de manière identique ou différente lors de chaque occurrence, F, CI, Br, NO₂, CN, un groupe alkyle ou alkoxy en chaîne droite ou ramifié ou cyclique comportant de 1 à 20 atomes de C, où un ou plusieurs groupes CH₂ non adjacents peuvent être remplacés par -O-, -S-, -NR¹- ou -CONR²- et où un ou plusieurs atomes de H peuvent être remplacés par F, ou un groupe aryle ou hétéroaryle comportant de 4 à 14 atomes de C, qui peuvent être substitués par un ou plusieurs radicaux non aromatiques R; où une pluralité de substituants R, à la fois sur le même cycle et également sur les deux cycles différents, peuvent à leur tour former ensemble un autre système de cycle mono- ou polycyclique;
R¹ et R² sont, de manière identique ou différente, H ou un radical hydrocarbone aliphatique ou aromatique comportant de 1 à 20 atomes de C;
a est 0, 1, 2, 3 ou 4;
b est 0, 1 ou 2;
par réaction d'un composé (la), (IIa), (IIIa) 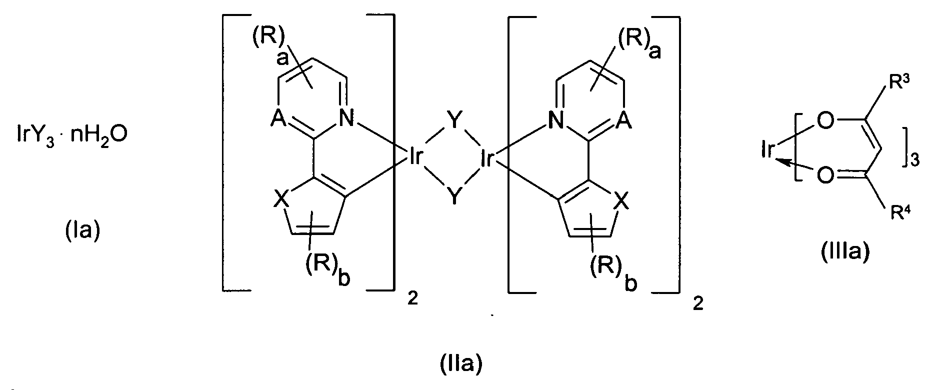 où
Y est de manière identique F, CI, Br, OH ou un groupe alkoxy en chaîne droite ou ramifié ou cyclique comportant de 1 à 8 atomes de C ou un groupe phénoxy,
R³, R⁴ sont identiques ou différents lors de chaque occurrence et présentent la signification de R¹ et R² ou CF₃;
avec un composé (Ib), (IIb) 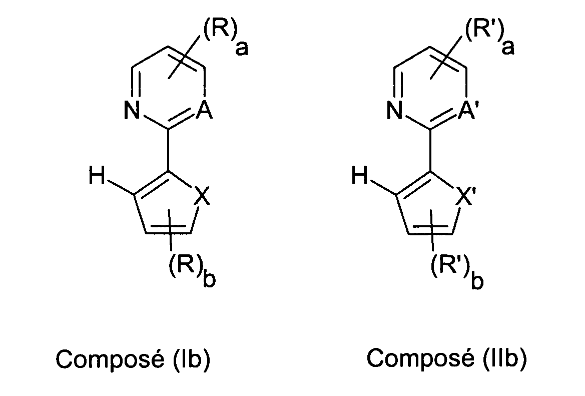 où les radicaux A, A', X, X', R, R', a et b présentent les significations mentionnées ci avant, avec ajout d'un acide de Lewis.

2. Procédé selon la revendication 1, **caractérisé en ce que** le matériau de départ contenant de l'iridium utilisé est IrCl₃, IrCl₃ n H₂O, IrBr₃, IrBr₃ n H₂O, di-µ-chlorotétrakis[(2-pyridinyl-κN)(phényl)-κC]diiridium(III), di-µ-chlorotétrakis[(2-pyridinyl-κN)(4',6'-difluorophényl)-κC]diiridium(III), di-µ-chlorotétrakis[(2-(3-méthyl)pyridinyl-κN)(6'-méthylphényl)-κC]diiridium(III), di-µ-chlorotétrakis[(2-(3-trifluorométhyl)pyridinyl-κN)-(6'-fluorophényl)-κC]diiridium(III), di-µ-chlorotétrakis[(2-pyridinyl-κN)(4'-fluorophényl)-κC]diiridium(III), di-µ-chlorotétrakis[(2-pyridinyl-κN)(4'-fluorophényl)-κC]diiridium(III), di-µ-chlorotétrakis[(2-(3-trifluorométhyl)pyridinyl-κN)(phényl)-κC]diiridium(III), di-µ-chlorotétrakis[(2-bis(3,5-trifluorométhyl)pyridinyl-κN)(phényl)-κC]diiridium(III) ou acétylacétonate de Ir(III).

3. Procédé selon les revendications 1 et/ou 2, **caractérisé en ce que** l'acide de Lewis contient, en tant que centre acide de Lewis, un élément issu des groupes principaux 3 et/ou 4 et/ou des sous-groupes 2 à 10.

4. Procédé selon une ou plusieurs des revendications 1 à 3, **caractérisé en ce que** l'acide de Lewis contient, en tant que centre acide de Lewis, un élément issu des groupes principaux 3 et/ou 4, de préférence B, Al ou Sn.

5. Procédé selon une ou plusieurs des revendications 1 à 4, **caractérisé en ce que** l'acide de Lewis utilisé est borate de triméthyle, borate de triéthyle, borate de triisopropyle, complexe trifluorure de bore/éther, fluorure d'aluminium(III), chlorure d'aluminium(III), bromure d'aluminium(III), iodure d'aluminium(III), butoxyde d'aluminium(III), éthoxyde d'aluminium(III), isopropoxyde d'aluminium(III), phénoxyde d'aluminium(III), chlorure d'étain(II), bromure d'étain(II), fluorure d'étain(II), iodure d'étain(II), chlorure d'étain(IV), bromure d'étain(IV), fluorure d'étain(IV) ou iodure d'étain(IV).

6. Procédé selon une ou plusieurs des revendications 1 à 3, **caractérisé en ce que** l'acide de Lewis contient, en tant que centre acide de Lewis, un élément issu des sous-groupes 2 à 10, de préférence Fe, Zn, Ti ou Zr.

7. Procédé selon une ou plusieurs des revendications 1 à 3 et 6, **caractérisé en ce que** l'acide de Lewis utilisé est chlorure de fer(III), bromure de fer(III), iodure de fer(III), chlorure de fer(II), bromure de fer(II), iodure de fer(II), chlorure de zinc(II), bromure de zinc(II), iodure de zinc(II), chlorure de titane(IV) ou de zirconium(IV), bromure de titane(IV) ou de zirconium(IV), fluorure de titane(IV) ou de zirconium(IV), iodure de titane(IV) ou de zirconium(IV), éthoxyde de titane(IV) ou de zirconium(IV), butoxyde de titane(IV) ou de zirconium(IV), méthoxyde de titane(IV) ou de zirconium(IV), triéthoxyde de chlorure de titane(IV) ou de zirconium(IV), triisopropoxyde de chlorure de titane(IV) ou de zirconium(IV), (2-éthylhexoxyde) de titane(IV) ou de zirconium(IV), fluorure de titane(IV) ou de zirconium(IV).

8. Procédé selon une ou plusieurs des revendications 1 à 7, **caractérisé en ce que** des mélanges d'acides de Lewis sont en option utilisés.

9. Procédé selon une ou plusieurs des revendications 1 à 8, **caractérisé en ce que** l'acide de Lewis est utilisé selon le rapport 0,01:1 à 10:1 par rapport au matériau de départ contenant de l'iridium.

10. Procédé selon une ou plusieurs des revendications 1 à 9, **caractérisé en ce que** le rapport du matériau de départ contenant de l'iridium, des composés de la formule (la, IIa, IIIa) et du ligand de la formule (Ib, IIb) est 1:1 à 1:100.

11. Procédé selon une ou plusieurs des revendications 1 à 10, **caractérisé en ce que** le solvant utilisé est décaline, naphthalène, sulfoxyde de diméthyle, xylène, anisole, éthylène glycol, propylène glycol, diméthyl éther de triéthylène glycol, diméthyl éther de poly(éthylène glycol) ou N-méthylpyrrolidinone (NMP), fluorure d'hydrogène ou dioxyde de carbone supercritique.

12. Procédé selon une ou plusieurs des revendications 1 à 11, **caractérisé en ce que** la réaction est mise en oeuvre dans une plage de températures de 110°C à 220°C, de préférence de 130 à 200°C.

13. Procédé selon une ou plusieurs des revendications 1 à 12, **caractérisé en ce que** la réaction est mise en oeuvre sur 5 à 80 h.
